# EUROPEAN PATENT APPLICATION

(11) **EP 4 383 084 A1**
(43) Date of publication of application: **12.06.2024**
(21) Application number: 23212571.6
(22) Date of filing: 28.11.2023
(51) Int. Cl.: G06F 15/78

(54) **MEMORY DEVICE AND OPERATING METHOD THEREOF**

(30) Priority: 02.12.2022 KR 20220166588
(71) Applicant: Samsung Electronics Co., Ltd., Suwon-si, Gyeonggi-do 16677 (KR)
(72) Inventor: Seo, Seungwoo, Suwon-si, Gyeonggi-do 16678 (KR); Cha, Sanghoon, Suwon-si, Gyeonggi-do 16678 (KR)
(74) Representative: Grünecker Patent- und Rechtsanwälte PartG mbB

(57) **Abstract**

A memory device includes: a plurality of memory banks divided by a plurality of channels comprising a first channel and a second channel; and a channel-level processing element (PE) configured to generate an in-memory computation result by performing an operation using a first partial result generated based on data stored in a memory bank of the first channel among the plurality of memory banks and a second partial result generated based on data stored in a memory bank of the second channel among the plurality of memory banks.

## Description

### BACKGROUND

### 1. Field

The present disclosure relates to a memory device and operating method thereof.

### 2. Description of Related Art

Efficient and high-performance neural network processing may be used for devices such as computers, smartphones, tablets, and wearables. As power consumption decreases and processing performance increases, special hardware accelerators for performing specialized tasks may be implemented for devices. For example, a plurality of hardware accelerators may be connected to generate a calculation graph for imaging and computer vision applications. Thus, subsystems for imaging and computer vision accelerations may include a plurality of special hardware accelerators with efficient streaming interconnections to transmit data between the hardware accelerators. A near-memory accelerator may refer to an accelerator implemented near a hardware accelerator. In-memory computing (IMC) may refer to hardware acceleration implemented inside a memory.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

The invention is claimed in the independent claims. Preferred embodiments are specified in the dependent claims.

In one or more general aspects, a memory device includes: a plurality of memory banks divided by a plurality of channels comprising a first channel and a second channel; and a channel-level processing element (PE) configured to generate an in-memory computation result by performing an operation using a first partial result generated based on data stored in a memory bank of the first channel among the plurality of memory banks and a second partial result generated based on data stored in a memory bank of the second channel among the plurality of memory banks.

The channel-level PE may be configured to transmit the in-memory computation result to a host processor.

The channel-level PE may include: a plurality of operators configured to apply an operation according to an instruction to partial operation results of the plurality of channels respectively; and an adder configured to, for the generating of the in-memory computation result, determine a sum of outputs of the plurality of operators of the plurality of channels.

The channel-level PE may include: a register configured to register the outputs of the plurality of operators; an instruction memory configured to store the instruction; and a decoder configured to control the plurality of operators, the adder, and the register by interpreting the instruction.

For the generating of the in-memory computation result, channel-level PE may be configured to: obtain a partial result corresponding to an operation on values stored in a respective memory channel among a plurality of operations belonging to the same task, during parallel execution of a plurality of tasks; store a partial result corresponding to a respective memory channel in a register area allocated for each of the tasks in a register corresponding to the respective memory channel; and generate the in-memory computation result by loading partial results generated for the same task in a plurality of memory channels from the register corresponding to the channel, and determining a sum of the loaded partial results through the adder.

For the generating of the in-memory computation result, channel-level PE may be configured to: based on a sum of products of values of memory banks belonging to the same memory channel, receive an intermediate result corresponding to the memory channel; accumulate received intermediate results by the plurality of operators; store a partial result obtained by the accumulating in a register; and generate the in-memory computation result by determining a sum of partial results stored in the register through the adder.

An intra-channel PE of the memory device may be configured to generate a first sum result by determining a sum of embedding vectors of banks in the same rank among embedding vectors selected as the same segment in a tensor to be determined, and, for the generating of the in-memory computation result, the channel-level PE may be configured to: obtain an intermediate result based on a sum of the first sum result and another first sum result in the same channel among the embedding vectors selected as the same segment; generate a partial result by accumulating intermediate results obtained from respective channels, and store a generated partial result in a register; and generate the in-memory computation result by determining a sum of partial results.

For the performing of the operation, the channel-level PE may be configured to perform any one or any combination of any two or more operations among addition, subtraction, multiplication, division, multiply-accumulate (MAC) operation, and reduction operation on inter-channel data.

The memory device may include an intra-channel PE configured to generate a partial result by performing an operation on data of memory banks belonging to the same channel among the plurality of memory banks.

For the performing of operation on data of the memory banks, the intra-channel PE may be configured to perform any one or any combination of any two or more operations among addition, subtraction, multiplication, division, MAC operation, and reduction operation on intra-channel data.

The memory device may include a bank-level PE configured to perform an operation on data of memory banks belonging to the same rank among the plurality of memory banks.

The memory device may include a rank-level PE configured to perform an operation between different memory ranks belonging to the same channel among a plurality of memory ranks.

The memory device may include: a first bank-level PE configured to generate a first bank-level result through an operation on data stored in different banks in the first channel; and a first rank-level PE configured to generate the first partial result based on the first bank-level result generated by the first bank-level PE.

The memory device may include: a second bank-level PE configured to generate a second bank-level result through an operation on data stored in different banks in the second channel; and a second rank-level PE configured to generate the second partial result based on the second bank-level result generated by the second bank-level PE.

The plurality of memory banks may form a tree structure.

The channel-level PE may be in a logic die of the memory device, and the plurality of memory banks may be in a core die of the memory device.

The logic die and a plurality of memory core dies may be stacked, and partial results of memory channels in the plurality of memory core dies may be collectively processed in the channel-level PE in the logic die.

A computation result obtained by the channel-level PE in the logic die may be transmitted to a host processor of a processor die through an interposer.

The channel-level PE may include a plurality of operators each corresponding to a respective one of the channels and configured to perform an operation between a partial result corresponding to the channel and a previously generated partial result stored in a register corresponding to the operator, and may include an adder configured to, for the generating of the in-memory computation result, determine a sum of outputs of the plurality of operators.

An electronic device may include: the memory device; and the host processor.

In one or more general aspects, a processor-implemented method of operating a memory device includes: generating a first partial result based on data stored in a memory bank of a first channel among a plurality of memory banks and generating a second partial result based on data stored in a memory bank of a second channel among the plurality of memory banks; and generating an in-memory computation result by performing an operation using the first partial result and the second partial result by a channel-level processing element (PE).

In one or more general aspects, a non-transitory computer-readable storage medium stores instructions that, when executed by a processor, configure the processor to perform any one, any combination, or all of operations and/or methods described herein.

In one or more general aspects, a memory device includes: a first memory rank comprising a bank-level processing element (PE) configured to generate a bank-level result through an operation on data stored in banks of the first memory rank; a first memory channel comprising the first memory rank, a second memory rank, and an intra-channel PE configured to generate a partial result by performing an operation on the bank-level result of the first memory rank and a bank-level result of the second memory rank; and a channel-level PE configured to generate an in-memory computation result by performing an operation using the partial result of the first memory channel and a partial result of a second memory channel, and to transmit the in-memory computation result to a host processor.

Other features and aspects will be apparent from the following detailed description, the drawings, and the claims.

### BRIEF DESCRIPTION OF THE DRAWINGS

FIGS. 1 and 2 illustrate examples of an electronic device according to one or more embodiments.
FIG. 3 illustrates an example of a memory device according to one or more embodiments.
FIG. 4 illustrates an example of processing elements (PEs) forming a tree structure of a memory device according to one or more embodiments.
FIG. 5 illustrates an example configuration of a channel-level PE of a memory device according to one or more embodiments.
FIG. 6 illustrates an example arrangement of a host processor and a memory device in an electronic device according to one or more embodiments.
FIGS. 7 and 8 illustrate examples of a method of operating a memory device according to one or more embodiments.
FIG. 9 illustrates an example operation performed in a memory device according to one or more embodiments.

Throughout the drawings and the detailed description, unless otherwise described or provided, the same drawing reference numerals will be understood to refer to the same or like elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

The terminology used herein is for describing various examples only and is not to be used to limit the disclosure. The articles "a," "an," and "the" are intended to include the plural forms as well, unless the context clearly indicates otherwise. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof.

Throughout the specification, when a component or element is described as being "on", "connected to," "coupled to," or "joined to" another component, element, or layer it may be directly (e.g., in contact with the other component or element) "on", "connected to," "coupled to," or "joined to" the other component, element, or layer or there may reasonably be one or more other components, elements, layers intervening therebetween. When a component or element is described as being "directly on", "directly connected to," "directly coupled to," or "directly joined" to another component or element, there can be no other elements intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

As used herein, the term "and/or" includes any one and any combination of any two or more of the associated listed items. The phrases "at least one of A, B, and C", "at least one of A, B, or C", and the like are intended to have disjunctive meanings, and these phrases "at least one of A, B, and C", "at least one of A, B, or C", and the like also include examples where there may be one or more of each of A, B, and/or C (e.g., any combination of one or more of each of A, B, and C), unless the corresponding description and embodiment necessitates such listings (e.g., "at least one of A, B, and C") to be interpreted to have a conjunctive meaning.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application. The use of the term "may" herein with respect to an example or embodiment, e.g., as to what an example or embodiment may include or implement, means that at least one example or embodiment exists where such a feature is included or implemented, while all examples are not limited thereto.

Hereinafter, examples will be described in detail with reference to the accompanying drawings. When describing the examples with reference to the accompanying drawings, like reference numerals refer to like components and a repeated description related thereto is omitted.

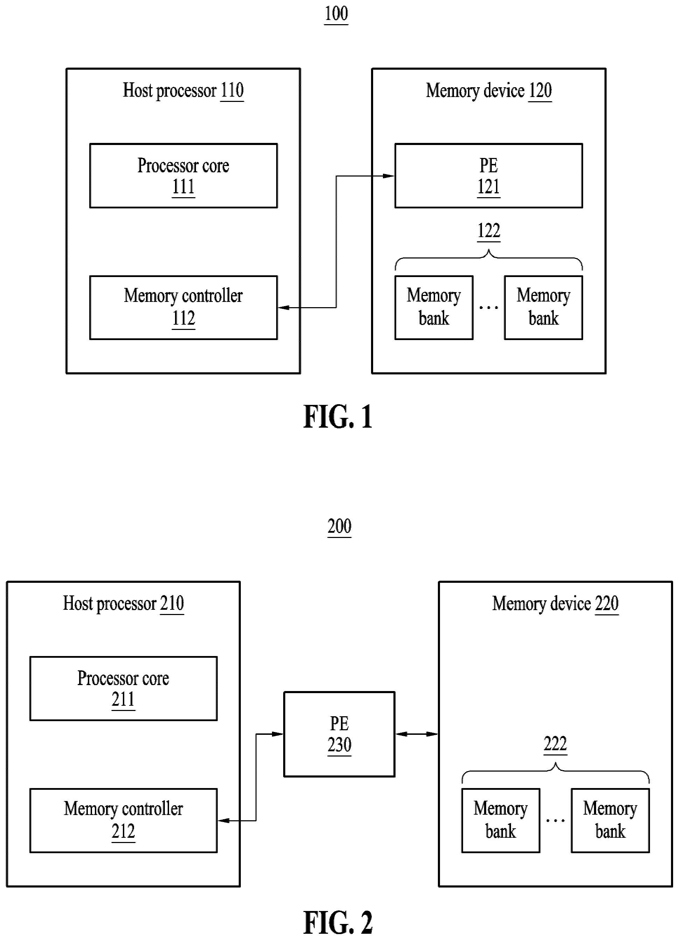

FIGS. 1 and 2 illustrate examples of an electronic device according to one or more embodiments.

According to an example embodiment, an electronic device 100 may include a host processor 110 and a memory device 120.

A host, which is a main management entity of a computer system (e.g., the electronic device 100), may be implemented as a host processor (e.g., the host processor 110) or a server. The host processor 110 may include, for example, a host central processing unit (CPU). For example, the host processor 110 may include a processor core 111 and a memory controller 112. The memory controller 112 may control the memory device 120. The memory controller 112 may transmit a command to the memory device 120. The host processor 110 may process data received from the memory device 120, through the processor core 111. As non-limiting examples, the electronic device 100 may be a mobile device such as a mobile phone, a smart phone, a PDA, a netbook, a tablet computer or a laptop computer, a wearable device such as a smart watch, a smart band or smart glasses, a computing device such as a desktop or a server, a home appliance such as a television, a smart television or a refrigerator, a security device such as a door lock, and/or a vehicle such as an autonomous vehicle or a smart vehicle.

The memory device 120 may include a memory area in which data is to be stored. The memory area may refer to an area (e.g., a physical area) in which data may be read from and/or written in a memory chip of a physical memory device (e.g., the memory device 120). As will be described in one or more non-limiting examples below, the memory area may be provided on a core die of the memory device 120. The memory device 120 may process data of the memory area in cooperation with the host processor 110. For example, the memory device 120 may process data based on a command received from the host processor 110. The memory device 120 may control the memory area in response to the command received from the host processor 110. The memory device 120 may include a processing element (PE) 121 and a plurality of memory banks 122. The memory device 120 may be separated from the host processor 110.

For example, the host processor 110 may manage an overall operation (or calculation) and assign an operation (e.g., processing-in-memory (PIM) and/or processing-near-memory (PNM)) that are to be implemented with acceleration to a controller of the memory device 120. An operation used herein may be interchangeably described as calculation and computation.

The memory banks 122 may be blocks of memory generated using all or some of memory chips of the memory device 120. The memory banks 122 may be grouped in a unit of memory ranks and/or memory channels. For example, a memory rank may represent a set of memory chips (e.g., dynamic random-access memory (DRAM) chips) that are connected to the same chip select and are simultaneously accessible, and a memory channel may represent a set of memory chips accessible through the same channel (e.g., memory channel).

An instruction described herein may include an instruction for executing an operation of a processor of the host processor 110, the memory device 120, or other devices and/or an operation of each component of the processor. For example, instructions (or program) executable by the host processor 110 may be stored in the memory device 120 or another memory device 120, but examples are not limited thereto.

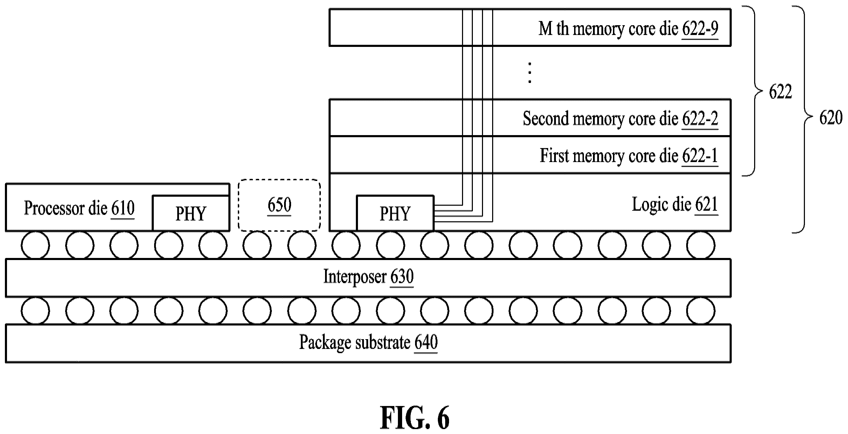

Although an example case (e.g., PIM) in which the PE 121 is included in the memory device 120 is described with reference to FIG. 1, examples are not limited thereto. For example, as illustrated in FIG. 2, a memory device 220 in an electronic device 200 may include a plurality of memory banks 222, and an operation using data of the memory device 220 may be performed by a PE 230 disposed outside the memory device 220. An operation result obtained by performing the operation by the PE 230 may be transmitted to a host processor 210 through a memory controller 212. The host processor 210 may process the operation result received through a processor core 211. The PE 230 may be disposed near the memory device 220. A non-limiting example arrangement of the PE 230 will be described in detail below with reference to FIG. 6.

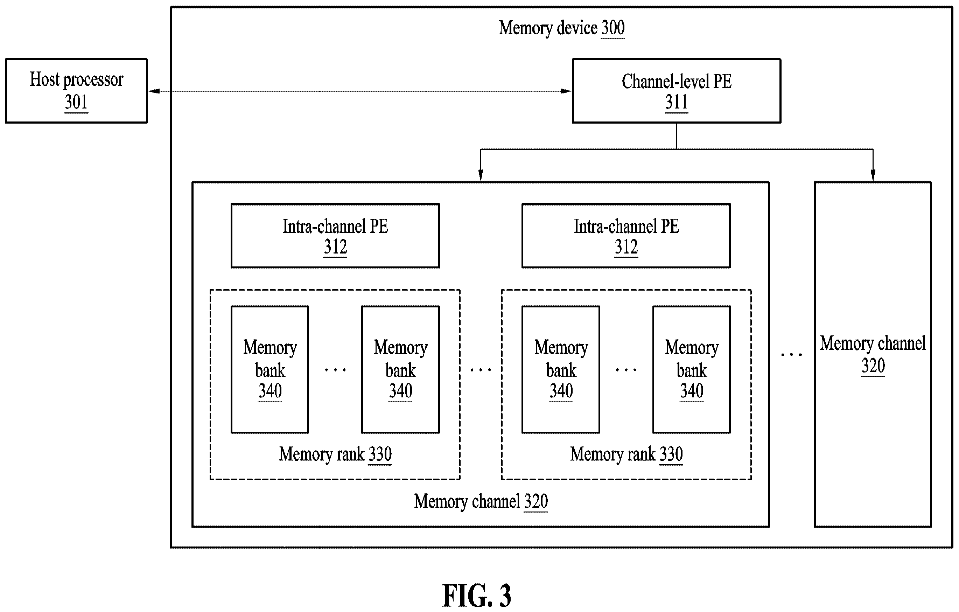

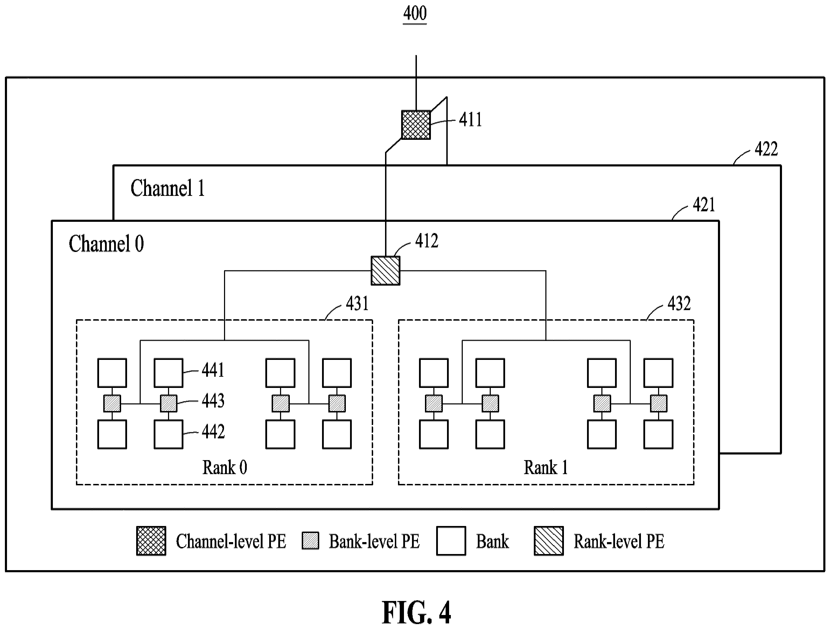

For example, there may be a single memory controller (e.g., the memory controller 112 or the memory controller 212) as illustrated in FIGS. 1 and 2. A host processor (e.g., the host processor 110 or the host processor 210) may process data of a plurality of memory channels and a plurality of memory devices through the memory controller (e.g., the memory controller 112 or the memory controller 212). However, examples are not limited thereto, and the host processor (e.g., the host processor 110 or the host processor 210) may include a plurality of memory controllers (e.g., each of the memory controller 112 and the memory controller 212 may be or include a plurality of memory controllers). The host processor (e.g., the host processor 110 or the host processor 210) may process data of a plurality of memory channels and a plurality of memory devices through the memory controllers. According to an example embodiment, a memory device may be a high-bandwidth memory (HBM) device, and memory ranks included in the memory device may be accessed through different memory channels, a non-limiting example of which will be described below with reference to FIGS. 3 and 4. However, examples are not limited thereto, and a topology of a memory device to be provided may vary according to a host processor (e.g., the host processor 110 or the host processor 210) and a board configuration.

FIG. 3 illustrates an example of a memory device according to one or more embodiments.

According to an example embodiment, a memory device 300 (e.g., the memory device 120 and the memory device 220 of FIGS. 1 and 2) may process data. The memory device 300 may manage a memory area by processing data to be stored in the memory area. The memory device 300 may be implemented as an HBM device. However, examples of the memory device 300 are not limited thereto, but the memory device 300 may be implemented as a volatile memory device or a non-volatile memory device. The volatile memory device may be implemented as a dynamic random-access memory (DRAM), a static RAM (SRAM), a thyristor RAM (T-RAM), a zero-capacitor RAM (Z-RAM), and/or a twin transistor RAM (TTRAM). The non-volatile memory device may be implemented as an electrically erasable programmable read-only memory (EEPROM), a flash memory, a magnetic RAM (MRAM), a spin-transfer torque (STT)-MRAM (STT-MRAM), a conductive bridging RAM (CBRAM), a ferroelectric RAM (FeRAM), a phase change RAM (PRAM), a resistive RAM (RRAM), a nanotube RRAM, a polymer RAM (PoRAM), a nano-floating gate memory (NFGM), a holographic memory, a molecular electronic memory device, and/or an insulator resistance change memory. For example, in addition to a host processor 301 receiving an in-memory computation result from the memory device 300, the memory device 300 may include a non-transitory computer-readable storage medium storing instructions that, when executed by the host processor 301, configure the host processor 301 to perform one or more operations of the host processor 301 (e.g., one or more operations performed based on the received in-memory computation result). Hereinafter, an HBM will be mainly described as an example of the memory device 300.

According to an example embodiment, the memory device 300 may include a plurality of memory banks 340 and a PE (e.g., the PE 121 and the PE 230 of FIGS. 1 and 2).

The memory banks 340 (e.g., the memory banks 122 and 222 of FIGS. 1 and 2) may be divided by a plurality of channels (e.g., memory channels) including a first channel and a second channel. As described above, a memory bank 340 may refer to a unit of memory that stores data and may also be referred to as a memory cell. The memory banks 340 may be divided by a unit of ranks and a unit of channels. For example, the memory device 300 may include a plurality of memory channels 320 (e.g., including a memory channel 320 accessible through the first channel (e.g., "channel 0") and another memory channel 320 accessible through the second channel (e.g., "channel 1")), and each memory channel 320 may include a plurality of memory ranks 330 each including a plurality of memory banks 340. The PE to be described below may perform an operation on data stored in the memory banks 340, an operation between bank groups into which the memory banks 340 are grouped, an operation between the memory ranks 330, and an operation between memory channels. The memory banks 340, the memory ranks 330, and the memory channels may be connected to the PE formed in a tree structure, a non-limiting example of which will be described in detail below with reference to FIG. 4.

The PE may process data stored in the memory area (e.g., the memory banks 340). The PE may perform an operation on data (e.g., vectors and embedding vectors) read from the memory banks 340 or an operation on intermediate results. The operation performed by the PE may include an arithmetic operation including at least one of addition, subtraction, multiplication, and/or division, a combination of any two or more arithmetic operations (e.g., a multiply-accumulate (MAC) operation), and/or a reduction operation. The reduction operation may refer to an operation that reduces a plurality of elements (e.g., values or vectors) to a single result (e.g., a single value or a single vector). For example, the reduction operation may include gathering vectors (e.g., embedding vectors) from an embedding table and adding them. However, examples are not limited thereto, and, as other non-limiting examples, the reduction operation may include finding a maximum or minimum value among a plurality of elements, a sum or product of all the elements, and/or a logical operation (e.g., logical conjunction (logical AND), logical disjunction (logical OR), exclusive OR (XOR), negative AND (NAND), negative-OR (NOR), and/or exclusive NOR (XNOR)). For example, the PE may execute computer-readable code (e.g., software) stored in a memory (e.g., the memory device 300 or another memory device) and instructions triggered by a processor. For example, the processor may be a hardware-implemented data processing device having a physically structured circuit to execute desired operations. The desired operations may include, for example, code or instructions included in the program. For example, the memory device 300 may store instructions that, when executed by the PE, configure the PE to perform the operation performed by the PE. The PE may include a channel-level PE 311 and an intra-channel PE 312.

The channel-level PE 311 may perform an operation based on data of two or more memory banks 340. At least one of the two or more memory banks 340 may belong to a channel different from a channel of another memory bank. The channel-level PE 311 may perform an operation using data stored in different memory channels. The channel-level PE 311 may also be referred to as an inter-channel PE or a channel PE. The channel-level PE 311 may be configured to perform at least one operation among addition, subtraction, multiplication, division, MAC operation, and/or reduction operation on inter-channel data.

According to an example embodiment, the channel-level PE 311 may generate the in-memory computation result by performing an operation using a first partial result that is based on data stored in a memory bank 340 of the first channel among the memory banks 340 and a second partial result that is based on data stored in a memory bank 340 of the second channel among the memory banks 340. The first channel and the second channel may be or correspond to different memory channels 320. The first partial result may be an intermediate result (e.g., an intermediate output or a partial sum (PSUM)) according to an operation using data stored in the first channel. The second partial result may be an intermediate result according to an operation using data stored in the second channel. A non-limiting example of an operation using data stored in each channel will be described in detail below with reference to FIG. 4. For example, the channel-level PE 311 may generate a final operation result (e.g., the in-memory computation result) by calculating (e.g., determining) a sum (or adding) of partial sums output from channels. The channel-level PE 311 may transmit the final operation result (e.g., the in-memory computation result) to the host processor 301. Thus, by generating the final operation result, the memory device 300 of one or more embodiments may minimize an operation amount (or an amount of calculation or computation) of the host processor 301, compared to a typical electronic device where the final operation result is generated by a host processor of the electronic device.

For example, the channel-level PE 311 may be implemented inside or near the memory device 300. FIG. 3 illustrates an example of the channel-level PE 311 implemented inside the memory device 300. For example, the channel-level PE 311 may access data stored in memory areas (e.g., a plurality of memory banks) without passing through a main data bus between the host processor 301 and the memory device 300. The channel-level PE 311 may process data fast by processing data of a plurality of memory banks simultaneously and/or in parallel.

The intra-channel PE 312 may generate a partial result (e.g., the first partial result and the second partial result) by performing an operation on data of memory banks 340 belonging to the same channel among a plurality of memory banks 340. The intra-channel PE 312 may also be referred to as an internal PE. The intra-channel PE 312 may be configured to perform at least one operation among addition, subtraction, multiplication, division, MAC operation, and/or reduction operation on intra-channel data. For example, the operation performed by the intra-channel PE 312 may include at least one of addition, subtraction, multiplication, and/or division on inter-bank or inter-rank data. The intra-channel PE 312 may include a bank-level PE and/or a rank-level PE.

The bank-level PE may perform an operation using data stored in different memory banks 340. The bank-level PE may also be referred to as an inter-bank PE or a bank PE.

The rank-level PE may perform an operation using data stored in different memory ranks 330. The rank-level PE may also be referred to as an inter-rank PE or a rank PE.

The PEs described above may process data by efficiently using an internal bandwidth of the memory device 300. The memory device 300 may process, in parallel, data in units of banks, ranks, and channels by performing a distributed operation function through PEs arranged for banks, ranks, and channels. Thus, a device of one or more embodiments may prevent latency in data access to a memory area and effectively reduce external bus traffic.

FIG. 4 illustrates an example of PEs forming a tree structure of a memory device according to one or more embodiments.

According to an example embodiment, a plurality of memory banks may form a tree structure. As will be described below, a plurality of memory banks connected through PEs in such a tree structure may be divided by units of channels and ranks. A final operation result from data stored in the memory banks may be generated in a channel-level PE 411.

A memory device 400 may include a plurality of memory channels. A memory channel corresponding to a channel may represent a memory (e.g., a memory core) of a portion corresponding to the channel in the memory device 400. For example, a host processor may transmit data of a first memory channel 421 through a first channel (e.g., "channel 0" as a zeroth memory channel) of a memory controller (e.g., the memory controller 112 of FIG. 1). For another example, the host processor may transmit data of a second memory channel 422 through a second channel (e.g., "channel 1" as a first memory channel) of the memory controller.

The PEs may include the channel-level PE 411 (e.g., the channel-level PE 311 of FIG. 3) and an intra-channel PE (e.g., the intra-channel PE 312 of FIG. 3). The intra-channel PE may include a bank-level PE and/or a rank-level PE. As described above, the bank-level PE may perform an operation on data of memory banks belonging to the same rank among a plurality of memory banks. The rank-level PE may perform an operation between different memory ranks belonging to the same channel among a plurality of memory ranks.

According to an example embodiment, the memory device 400 may include a bank-level PE and a rank-level PE for each memory channel. In the example of FIG. 4, the memory device 400 may include a memory channel corresponding to the first channel (e.g., "channel 0") and a memory channel corresponding to the second channel (e.g., "channel 1").

A first bank-level PE 443 may generate a first bank-level result (e.g., a first inter-bank result) through an operation on data stored in different banks in the first channel. The first bank-level result may be generated based on an operation between memory banks 441 and 442 or between bank groups belonging to the same memory rank (e.g., a first rank 431). For example, a first bank-level result may be generated for each memory rank. In an example of FIG. 4, a first bank-level result for the first rank 431 (e.g., "rank 0") and a first bank-level result for a second rank 432 (e.g., "rank 1") may be generated. A first rank-level PE 412 may generate a first partial result based on the first bank-level result from the first bank-level PE 443. The first rank-level PE 412 may calculate the first partial result through an operation between (e.g., a summation of) first bank-level results of memory ranks (e.g., including the first bank-level result for rank 0 and the first bank-level result for rank 1). The first partial result, which is a partial result corresponding to a first memory channel, may be a result of an operation performed using data stored in memory banks belonging to the first memory channel among pieces of data used for a target task.

Similarly, a second bank-level PE of the second memory channel 422 may generate a second bank-level result through an operation on data stored in different banks in the second channel (e.g., in the second memory channel 422). The second bank-level result may be generated based on an operation between memory banks 441 and 442 or between bank groups belonging to the same memory rank in the second channel. For example, a second bank-level result may be generated for each memory rank of the second channel. A second rank-level PE of the second memory channel 422 may generate a second partial result based on the second bank-level result from the second bank-level PE. The second rank-level PE 412 may calculate the second partial result through an operation between second bank level results of memory ranks. The second partial result, which is a partial result corresponding to a second memory channel, may be a result of an operation performed using data stored in memory banks belonging to the second memory channel among pieces of data used for a target task.

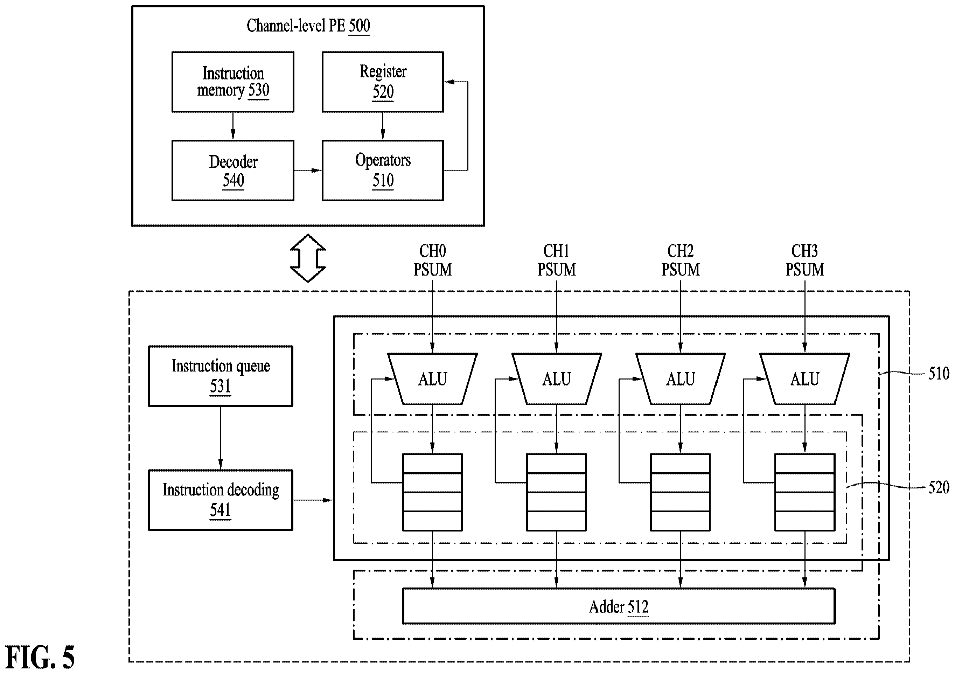

The channel-level PE 411 may generate a final operation result by performing an operation between the first partial result and the second partial result described above. For example, as will be described below with reference to FIG. 5, the channel-level PE 411 may process intermediate results received from memory channels to generate a partial result corresponding to a corresponding memory channel. The channel-level PE 411 may perform an operation (e.g., summation) between partial results of the memory channels.

FIG. 5 illustrates an example configuration of a channel-level PE of a memory device according to one or more embodiments.

According to an example embodiment, a channel-level PE 500 may perform an operation on partial results generated in a plurality of memory channels. For example, the channel-level PE 500 may perform a channel-level reduction operation. The channel-level reduction operation may be implemented by an operator and an adder 512 (e.g., an adder tree). The channel-level PE 500 may perform an elementwise operation or a MAC operation according to a corresponding instruction. For example, the channel-level PE 500 may include operators 510, a register 520, an instruction memory 530, and a decoder 540.

The instruction memory 530 may store an instruction. The instruction may include a target task to be performed and/or a plurality of operations (e.g., a series of operations) for the target task. For example, the instruction may indicate the target task and may be matched to a register area in the register 520 in which a result (e.g., an intermediate result or a partial result) of the target task is to be stored. The instruction memory 530 may receive the instruction from a host processor and store the received instruction. A controller of a memory device may process data of a memory area according to the received instruction. For example, the instruction may include an instruction for writing, reading, moving, or deleting data of the memory area, an instruction for executing an acceleration logic, and an instruction for allowing or restricting access to the memory area. The controller may receive information on data stored in memory banks from the host processor and read the information. For example, the controller may write data in a memory bank and output information on the written data to the host processor. The instruction memory 530 may include an instruction queue 531. The instruction queue 531 may be a queue that stores instructions for performing operations. The instruction queue 531 may store an instruction for a reduction operation matched to an incoming command.

The decoder 540 may interpret instructions to control the operators 510, the adder 512, and the register 520. The decoder 540 may interpret an instruction (e.g., a PIM instruction) and a memory command through instruction decoding 541. Through the decoder 540, operations according to the instructions and register areas matched to the instructions may be identified.

The operators 510 (or calculators) may individually apply operations according to an instruction to partial operation results of a plurality of channels. The operators 510 may perform the operations according to the instruction. Each operator may perform an arithmetic operation. The arithmetic operation may include at least one of addition, subtraction, multiplication, division, and/or reduction operation. The operators 510 may each include an arithmetic logic unit (ALU), for example. The ALU may be an element configured to perform four fundamental arithmetic operations including at least one of addition, subtraction, multiplication, and/or division. The operators 510 may accumulate or store values in the register 520 matched to the instruction. For example, an operator corresponding to one of a plurality of memory channels may process an intermediate result value of the one memory channel. For example, when a plurality of tasks is executed in parallel, an operator corresponding to each channel may perform respective operations corresponding to the tasks. The register 520 may store results of the operations corresponding to the tasks by classifying the results by each channel, such that the results of the operations corresponding to the tasks are distinguished from each other.

The register 520 may store outputs of the operators 510 for each task. For example, a plurality of registers may respectively correspond to memory channels (e.g., channels CH0, CH1, CH2, and CH3). As illustrated in FIG. 5, an operator corresponding to a channel and a register 520 corresponding to the channel may be connected. The register 520 corresponding to the channel may include a plurality of register areas, and each register area may be matched to an instruction for a target task. For example, results (e.g., intermediate results or partial results) of operations for the same task may be stored in the same register area or read from the same register area. Accordingly, the results of the operations may be managed by being classified by each task and each memory channel. For example, an operator corresponding to a first channel may sequentially receive intermediate results (e.g., CH0 PSUM) of the first channel based on an operation for a target task. In this example, the operator may perform an operation (e.g., summation or accumulation) between an intermediate result (e.g., CH0 PSUM) that is previously stored in a register area corresponding to the target task in the register 520 and an intermediate result that is currently received. A result of an operation between intermediate results for a memory channel may be stored in the register 520 as a partial result for the memory channel.

As described above, when generating an output for each channel, the memory device may generate a partial output for each task for each channel. For example, the channel-level PE 500 may store a first vector (e.g., an intermediate result) used for an operation for a first task in a portion (e.g., a register area) of the register 520 allocated to the first task. When obtaining an additional vector (e.g., an additional intermediate result) for the first task, the channel-level PE 500 may perform an operation that is based on the additional vector along with the first vector stored in the portion allocated for the first task in the register 520. Similarly, the channel-level PE 500 may store a second vector used for an operation for a second task in a portion of the register 520 allocated to the second task.

In addition, the operators 510 may include the adder 512. The adder 512 may calculate a sum of outputs (e.g., partial results accumulated for each channel) of the operators 510 of a plurality of channels. For example, the adder 512 may generate a final operation result (e.g., an in-memory computation result) by calculating a sum of accumulated partial results for each channel (e.g., memory channel) among a plurality of memory channels.

According to an example embodiment, the channel-level PE 500 may obtain a partial result corresponding to an operation on values stored in memory channels among a plurality of operations belonging to the same task, during parallel execution of a plurality of tasks. The channel-level PE 500 may store a partial result corresponding to a corresponding channel in a register area allocated for each task in the register 520 corresponding to the channel. The channel-level PE 500 may load, from the register 520 corresponding to each channel, partial results generated for the same task from a plurality of memory channels and calculate a sum of the partial results through the adder 512 to generate the in-memory computation result.

For example, the channel-level PE 500 may perform an accumulation of matrix products as a target task. The channel-level PE 500 may receive an intermediate result corresponding to a corresponding memory channel based on a sum of products of values of memory banks belonging to the same memory channel. The values of the memory banks may be, for example, a node value of each node in a neural network and a connection weight value applied to the node value. For example, an intermediate result may be generated by a rank-level PE. The channel-level PE 500 may accumulate received intermediate results by the operators 510. The channel-level PE 500 may store a partial result obtained by the accumulation in the register 520. The channel-level PE 500 may generate the in-memory computation result by calculating a sum of partial results stored in the register 520 through the adder 512.

For another example, the channel-level PE 500 may perform a sparse vector operation (e.g., SparseLengthsSum). An intra-channel PE (e.g., a rank-level PE or a bank-level PE) of the memory device may generate a first sum result by calculating a sum of embedding vectors of banks in the same rank among embedding vectors selected as the same segment in a tensor which is a target of an operation. The channel-level PE 500 may obtain an intermediate result based on a sum of different first sum results in the same channel among embedding vectors selected as the same segment as the first sum result. The channel-level PE 500 may generate a partial result by accumulating intermediate results obtained for respective channels through the operators 510 and store generated partial results in the register 520. The channel-level PE 500 may generate the in-memory computation result by calculating a sum of the partial results.

For example, as illustrated in FIG. 4, PEs from inside a memory channel to a channel level may form a tree structure. The channel-level PE 500 of one or more embodiments may maximize an internal bandwidth by accelerating an embedding lookup operation, using the tree structure described above.

FIG. 6 illustrates an example arrangement of a host processor and a memory device in an electronic device according to one or more embodiments.

According to an example embodiment, a channel-level PE may be disposed in a logic die 621 of a memory device 620. A plurality of memory banks may be disposed in a core die 622 of the memory device 620. For example, in the memory device 620 implemented as an HBM, the logic die 621 and a plurality of memory core dies 622-1, 622-2, ..., and 622-9 may be stacked. The logic die 621 of the HBM may spatially afford to have an element (e.g., an operator performing a MAC operation or a reduction operation, and a register) having various functions including an adder tree. FIG. 6 illustrates M memory core dies (e.g., 622-1, 622-2, ...., and 622-9), in which M denotes an integer greater than or equal to 1. Although each memory core die is illustrated as being horizontal in FIG. 6, a memory channel may be formed by vertically crossing the M memory core dies 622-1, 622-2, ..., and 622-9. For example, N memory channels may be formed across the M memory core dies 622-1, 622-2, ...., and 622-9, in which N denotes an integer greater than or equal to 1.

Partial results of memory channels disposed in a plurality of memory core dies may be processed collectively in the channel-level PE disposed in the logic die 621. The channel-level PE disposed in the logic die 621 may process a partial output (e.g., a partial result) generated for each channel unit. A computation result obtained by the channel-level PE of the logic die 621 may be transmitted to a host processor of a processor die 610 through an interposer 630. For example, a final operation result may be transmitted to a physical layer (indicated as PHY) of the processor die 610 via the interposer 630, through a physical layer (PHY) of the logic die 621. For example, the interposer 630 may be disposed on a package substrate 640, and the processor die 610 and the memory device 620 may be disposed on the interposer 630.

According to an example embodiment, the memory device 620 may support an inter-channel operation in a memory, and thus overhead in the host processor may be reduced in a process of generating a final result.

For example, implementation of PIM in which the channel-level PE is disposed in the logic die 621 is mainly described herein, but examples are not limited thereto. For another example, the channel-level PE may also be disposed in a space 650 between the host processor and the memory device 620. That is, the channel-level PE may also be disposed in the space 650 near the host processor to be implemented as PNM.

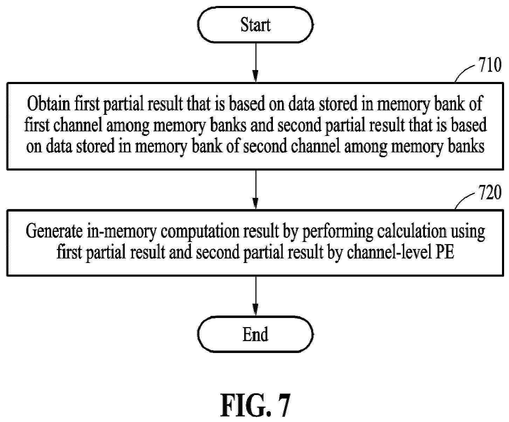

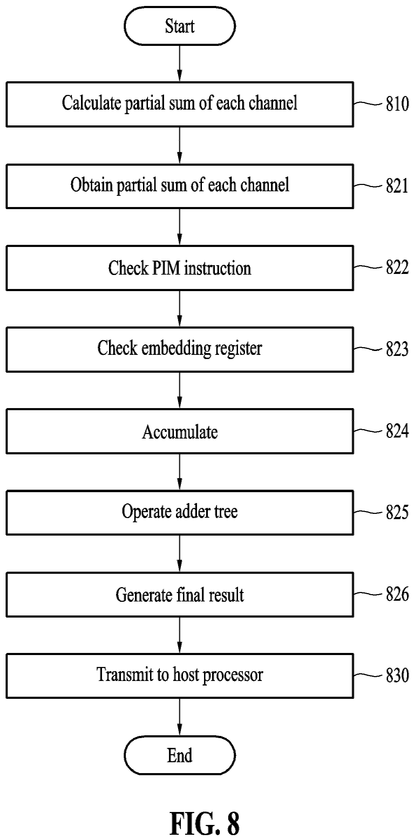

FIGS. 7 and 8 illustrate examples of a method of operating a memory device according to one or more embodiments.

FIG. 7 illustrates overall operations of a memory device.

In operation 710, the memory device may obtain a first partial result that is based on data stored in a memory bank of a first channel among a plurality of memory banks and a second partial result that is based on data stored in a memory bank of a second channel among the memory banks. As described above, the first partial result may be generated by intra-channel PEs belonging to the first channel, and the second partial result may be generated by intra-channel PEs belonging to the second channel.

In operation 720, the memory device may generate an in-memory computation result by performing an operation using the first partial result and the second partial result by a channel-level PE. For example, the channel-level PE may add elementwise the first partial result (e.g., an embedding vector) and the second partial result (e.g., another embedding vector).

However, examples are not limited thereto, and the memory device may perform at least one of the operations described above with reference to FIGS. 1 to 16 in parallel or in a time series. In addition, although in-memory computing (IMC) is mainly described herein as an example, examples are not limited thereto. For example, as described above with reference to FIG. 6, the channel-level PE may be disposed in an area near a host processor.

FIG. 8 illustrates example operations of a channel-level PE illustrated in FIG. 5.

For example, in operation 810, the memory device may calculate a partial sum (e.g., a partial output) of each channel. For example, intra-channel PEs belonging to each memory channel of the memory device may calculate a partial sum (e.g., PSUM) corresponding to a corresponding channel. For example, embedding vectors of an embedding table corresponding to a target task may be distributed to a plurality of memory banks, a plurality of memory ranks, and a plurality of memory channels. In this example, PEs corresponding to a memory rank and a memory channel to which a corresponding embedding vector belongs may perform a related operation (or calculation) (e.g., summation).

In operation 821, the channel-level PE of the memory device may obtain a partial sum of each channel.

In operation 822, a decoder of the channel-level PE may check a PIM instruction. The decoder may identify operations for a target task corresponding to the PIM instruction.

In operation 823, the decoder may check an embedding register. For example, the decoder may interpret an instruction stored in an instruction queue and determine a register area in which intermediate results corresponding to a corresponding channel of the target task are to be accumulated.

In operation 824, an operator of the channel-level PE may accumulate a partial output generated in a memory channel in the register area determined in operation 823.

The channel-level PE may repeat operations 810 to 824 described above until accumulated results are completed in all the channels.

In operation 825, the channel-level PE may calculate a sum of partial results by operating an adder tree. In operation 826, the channel-level PE may generate a final result by calculating a sum of all the partial results.

In operation 830, the channel-level PE may transmit the final result to a host processor.

According to an example embodiment, the memory device may accelerate an embedding lookup operation inside a memory using PIM and minimize a data movement between a host and the memory through an inter-channel operation. In addition, the memory device may employ the channel-level reduction operation described above to reduce overhead of the host processor. The memory device may thus exhibit the performance improved by approximately 2.8 times on average, compared to that exhibited when performing an embedding lookup only with the host processor.

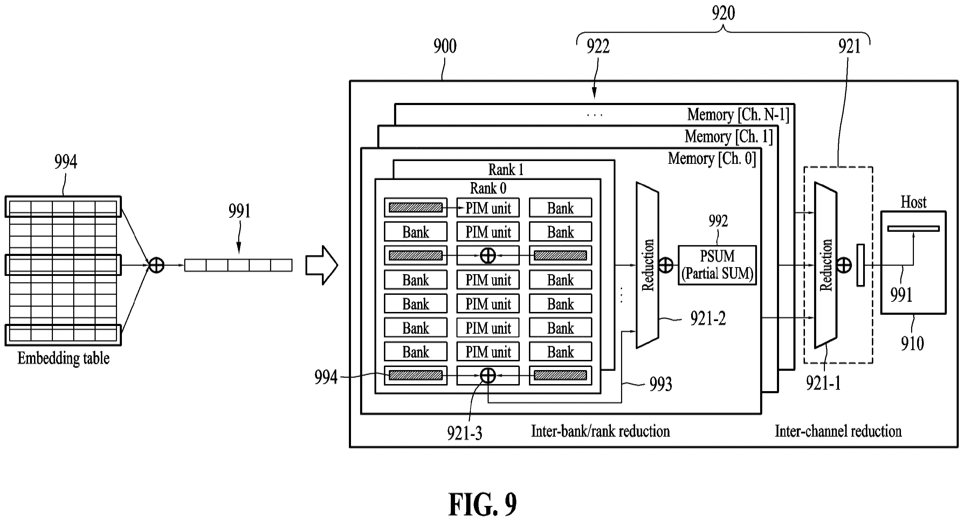

FIG. 9 illustrates an example operation performed in a memory device according to one or more embodiments.

An example of performing an embedding lookup operation by an electronic device 900 of one or more embodiments having a memory device 920 will be described hereinafter. The embedding lookup operation may include reading embedding vectors and adding up all the read embedding vectors. In an example, access to the embedding vectors may be considerably sparse and may randomly occur, and cache utilization may thus decrease. For example, embedding vectors 994 to be used for an operation may be stored in a plurality of memory banks, and these memory banks may be distributed to a plurality of memory ranks and distributed furthermore to a plurality of memory channels. When receiving, as a PIM input, a memory address of the embedding vectors 994 to be used for the operation, the memory device 920 may read, from each memory bank, the embedding vectors 994 to be calculated.

As described above, the memory device 920 may calculate a sum of the embedding vectors 994 stored in memory banks through PEs connected in a tree structure within each memory channel. A plurality of memory channels may be disposed in a memory core die 922 (e.g., the memory core die 922 may include a plurality of memory core dies). A bank-level PE 921-3 may obtain a sum 993 of data (e.g., the embedding vectors 994) between banks. A rank-level PE 921-2 may obtain a partial sum (PSUM) 992 (e.g., a partial result) by applying a reduction operation to sums received from memory ranks. Until a partial sum is obtained, an internal bandwidth may be used through PEs in a memory. For example, the partial sum may vary depending on the characteristics of an embedding table or input data.

The memory device 920 may generate a final operation result 991 by performing an inter-channel operation through a channel-level PE 921-1 disposed in a logic die 921.

The embedding lookup operation described above may be an operation used in a recommendation system of a graphics processing unit (GPU). The memory channels may be connected to a host processor 910. The final operation result 991 generated through a reduction operation by the channel-level PE 921-1 of the logic die 921 disposed in the middle may be transmitted to the host processor 910.

According to an example embodiment, the memory device 920 and/or the electronic device 900 may support an inter-channel operation in PIM. The memory device 920 and/or the electronic device 900 of one or more embodiments may effectively accelerate an embedding lookup of a deep learning recommendation model (DLRM) and a sparse matrix multiplication of a graph neural network (GNN), as a memory-centric operation. The memory device 920 and/or the electronic device 900 may be applied to accelerate DLRMs or various high-performance computing (HPC) applications using at least one of the embedding lookup or the sparse matrix multiplication. The memory device 920 may also be implemented as PIM or PNM. The memory device 920 may be provided in a portable device or a server.

However, the memory device 920 is not limited to being applied to the deep learning models described above but may be applied to various applications (e.g., the sparse matrix multiplication) having a characteristic of memory bandwidth bottleneck.

The memory device 920 and/or the electronic device 900 of one or more embodiments may also accelerate a gather-and-reduction operation in such a recommender system. The gather-and-reduction operation may include gathering and adding vectors (e.g., embedding vectors) from the embedding table. The gather-and-reduction operation, which is the most used operation in the recommendation system, may occupy approximately 70% of an operation rate of the DLRM. The performance of processing the gather-and-reduction operation may be determined by the speed of reading embedding vectors from the memory device 920.

The memory device 920 and/or the electronic device 900 of one or more embodiments may accelerate the gather-and-reduction operation by using a tree structure of a memory data path. The memory device 920 implemented as PIM may activate a plurality of memory banks, and process data read from the memory banks by PEs formed in the tree structure. The memory device 920 of one or more embodiments may thereby maximize the use of internal bandwidth.

The memory device 920 of one or more embodiments may maximize the use of internal bandwidth by using, for example, three-step parallelism: parallelism between memory banks, parallelism between groups of memory banks, and parallelism between memory ranks. In a typical memory device, when the final operation result 991 is not generated within three steps, an intermediate result value (e.g., a partial output) may be transmitted to the host processor 910. In this example, the host processor 910 may perform an operation (or calculation), which may limit the acceleration. In the typical memory device, as the number of memory channels increases, the number of partial outputs may increase, which may cause additional host overhead. In the typical memory device, a spare area may be small on a data path between memory banks or a data path between bank groups, and only PEs supporting limited operations may thus be arranged.

According to one or more embodiments, when performing an operation using data (e.g., vectors) present in different memory channels, the memory device 920 and/or the electronic device of one or more embodiments may perform an operation (e.g., a reduction operation) on partial outputs (e.g., partial results) of each memory channel to generate an in-memory computation result (e.g., the final operation result 991). The memory device 920 and/or the electronic device of one or more embodiments may provide the final operation result 991, instead of the partial outputs, from the host processor 910 to accelerate an operation.

The electronic devices, host processors, memory devices, processor cores, memory controllers, PEs, memory banks, memory channels, operators, registers, instruction memories, decoders, adders, processor dies, core dies, interposers, package substrates, memory core dies, logic dies, electronic device 100, host processor 110, memory device 120, processor core 111, memory controller 112, PE 121, memory banks 122, electronic device 200, processor core 211, memory controller 212, PE 230, memory device 220, memory banks 222, host processor 301, memory device 300, channel-level PE 311, memory channel 320, intra-channel PE 312, memory banks 340, memory device 400, channel-level PE 411, first memory channel 421, second memory channel 422, first rank-level PE 412, memory banks 441 and 442, first bank-level PE 443, channel-level PE 500, operators 510, register 520, instruction memory 530, decoder 540, adder 512, processor die 610, memory device 620, core die 622, interposer 630, package substrate 640, electronic device 900, host processor 910, memory device 920, memory core die 922, logic die 921, and other apparatuses, devices, units, modules, and components disclosed and described herein with respect to FIGS. 1-9 are implemented by or representative of hardware components. As described above, or in addition to the descriptions above, examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. As described above, or in addition to the descriptions above, example hardware components may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 1-9 that perform the operations described in this application are performed by computing hardware, for example, by one or more processors or computers, implemented as described above implementing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media, and thus, not a signal per se. As described above, or in addition to the descriptions above, examples of a non-transitory computer-readable storage medium include one or more of any of read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks, and any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above and all drawing disclosures, the scope of the invention is specified by the enclosed claims.

### The following is a list of further preferred embodiments of the invention:

Embodiment 1. A memory device comprising:
   a plurality of memory banks divided by a plurality of channels comprising a first channel and a second channel; and
   a channel-level processing element (PE) configured to generate an in-memory computation result by performing an operation using a first partial result generated based on data stored in a memory bank of the first channel among the plurality of memory banks and a second partial result generated based on data stored in a memory bank of the second channel among the plurality of memory banks.
Embodiment 2. The memory device of embodiment 1, wherein the channel-level PE is configured to transmit the in-memory computation result to a host processor.
Embodiment 3. The memory device of embodiment 1, wherein the channel-level PE comprises:
   a plurality of operators configured to apply an operation according to an instruction to partial operation results of the plurality of channels respectively; and
   an adder configured to, for the generating of the in-memory computation result, determine a sum of outputs of the plurality of operators of the plurality of channels.
Embodiment 4. The memory device of embodiment 3, wherein the channel-level PE comprises:
   a register configured to register the outputs of the plurality of operators;
   an instruction memory configured to store the instruction; and
   a decoder configured to control the plurality of operators, the adder, and the register by interpreting the instruction.
Embodiment 5. The memory device of embodiment 3, wherein, for the generating of the in-memory computation result, channel-level PE is configured to:
   obtain a partial result corresponding to an operation on values stored in a respective memory channel among a plurality of operations belonging to the same task, during parallel execution of a plurality of tasks;
   store a partial result corresponding to a respective memory channel in a register area allocated for each of the tasks in a register corresponding to the respective memory channel; and
   generate the in-memory computation result by loading partial results generated for the same task in a plurality of memory channels from the register corresponding to the channel, and determining a sum of the loaded partial results through the adder.
Embodiment 6. The memory device of embodiment 3, wherein, for the generating of the in-memory computation result, channel-level PE is configured to:
   based on a sum of products of values of memory banks belonging to the same memory channel, receive an intermediate result corresponding to the memory channel;
   accumulate received intermediate results by the plurality of operators;
   store a partial result obtained by the accumulating in a register; and
   generate the in-memory computation result by determining a sum of partial results stored in the register through the adder.
Embodiment 7. The memory device of embodiment 3, wherein
   an intra-channel PE of the memory device is configured to generate a first sum result by determining a sum of embedding vectors of banks in the same rank among embedding vectors selected as the same segment in a tensor to be determined, and
   for the generating of the in-memory computation result, the channel-level PE is configured to:
      obtain an intermediate result based on a sum of the first sum result and another first sum result in the same channel among the embedding vectors selected as the same segment;
      generate a partial result by accumulating intermediate results obtained from respective channels, and store a generated partial result in a register; and
      generate the in-memory computation result by determining a sum of partial results.
Embodiment 8. The memory device of embodiment 1, wherein, for the performing of the operation, the channel-level PE is configured to perform any one or any combination of any two or more operations among addition, subtraction, multiplication, division, multiply-accumulate (MAC) operation, and reduction operation on inter-channel data.
Embodiment 9. The memory device of embodiment 1, further comprising an intra-channel PE configured to generate a partial result by performing an operation on data of memory banks belonging to the same channel among the plurality of memory banks.
Embodiment 10. The memory device of embodiment 9, wherein, for the performing of operation on data of the memory banks, the intra-channel PE is configured to perform any one or any combination of any two or more operations among addition, subtraction, multiplication, division, MAC operation, and reduction operation on intra-channel data.
Embodiment 11. The memory device of embodiment 1, further comprising a bank-level PE configured to perform an operation on data of memory banks belonging to the same rank among the plurality of memory banks.
Embodiment 12. The memory device of embodiment 1, further comprising a rank-level PE configured to perform an operation between different memory ranks belonging to the same channel among a plurality of memory ranks.
Embodiment 13. The memory device of embodiment 1, further comprising:
   a first bank-level PE configured to generate a first bank-level result through an operation on data stored in different banks in the first channel; and
   a first rank-level PE configured to generate the first partial result based on the first bank-level result generated by the first bank-level PE.
Embodiment 14. The memory device of embodiment 1, further comprising:
   a second bank-level PE configured to generate a second bank-level result through an operation on data stored in different banks in the second channel; and
   a second rank-level PE configured to generate the second partial result based on the second bank-level result generated by the second bank-level PE.
Embodiment 15. The memory device of embodiment 1, wherein the plurality of memory banks forms a tree structure.
Embodiment 16. The memory device of embodiment 1, wherein
   the channel-level PE is in a logic die of the memory device, and
   the plurality of memory banks is in a core die of the memory device.
Embodiment 17. The memory device of embodiment 16, wherein
   the logic die and a plurality of memory core dies are stacked, and
   partial results of memory channels in the plurality of memory core dies are collectively processed in the channel-level PE in the logic die.
Embodiment 18. The memory device of embodiment 16, wherein a computation result obtained by the channel-level PE in the logic die is transmitted to a host processor of a processor die through an interposer.
Embodiment 19. The memory device of embodiment 1, wherein
   the channel-level PE comprises a plurality of operators each corresponding to a respective one of the channels and configured to perform an operation between a partial result corresponding to the channel and a previously generated partial result stored in a register corresponding to the operator, and
   an adder configured to, for the generating of the in-memory computation result, determine a sum of outputs of the plurality of operators.
Embodiment 20. An electronic device comprising:
   the memory device of embodiment 2; and
   the host processor.
Embodiment 21. A processor-implemented method of operating a memory device, comprising:
   generating a first partial result based on data stored in a memory bank of a first channel among a plurality of memory banks and generating a second partial result based on data stored in a memory bank of a second channel among the plurality of memory banks; and
   generating an in-memory computation result by performing an operation using the first partial result and the second partial result by a channel-level processing element (PE).
Embodiment 22. A non-transitory computer-readable storage medium storing instructions that, when executed by one or more processors, configure the one or more processors to perform the method of embodiment 21.
Embodiment 23. A memory device comprising:
   a first memory rank comprising a bank-level processing element (PE) configured to generate a bank-level result through an operation on data stored in banks of the first memory rank;
   a first memory channel comprising the first memory rank, a second memory rank, and an intra-channel PE configured to generate a partial result by performing an operation on the bank-level result of the first memory rank and a bank-level result of the second memory rank; and
   a channel-level PE configured to generate an in-memory computation result by performing an operation using the partial result of the first memory channel and a partial result of a second memory channel, and to transmit the in-memory computation result to a host processor.

## Claims

1. A memory device comprising:
a plurality of memory banks divided by a plurality of channels comprising a first channel and a second channel; and
a channel-level processing element, PE, configured to generate an in-memory computation result by performing an operation using a first partial result generated based on data stored in a memory bank of the first channel among the plurality of memory banks and a second partial result generated based on data stored in a memory bank of the second channel among the plurality of memory banks.

2. The memory device of claim 1, wherein the channel-level PE is configured to transmit the in-memory computation result to a host processor.

3. The memory device of claim 1 or 2, wherein the channel-level PE comprises:
a plurality of operators configured to apply an operation according to an instruction to partial operation results of the plurality of channels respectively; and
an adder configured to, for the generating of the in-memory computation result, determine a sum of outputs of the plurality of operators of the plurality of channels.

4. The memory device of claim 3, wherein the channel-level PE comprises:
a register configured to register the outputs of the plurality of operators;
an instruction memory configured to store the instruction; and
a decoder configured to control the plurality of operators, the adder, and the register by interpreting the instruction.

5. The memory device of claim 3, wherein, for the generating of the in-memory computation result, channel-level PE is configured to:
obtain a partial result corresponding to an operation on values stored in a respective memory channel among a plurality of operations belonging to the same task, during parallel execution of a plurality of tasks;
store a partial result corresponding to a respective memory channel in a register area allocated for each of the tasks in a register corresponding to the respective memory channel; and
generate the in-memory computation result by loading partial results generated for the same task in a plurality of memory channels from the register corresponding to the channel, and determining a sum of the loaded partial results through the adder, or
wherein, for the generating of the in-memory computation result, channel-level PE is configured to:
based on a sum of products of values of memory banks belonging to the same memory channel, receive an intermediate result corresponding to the memory channel;
accumulate received intermediate results by the plurality of operators;
store a partial result obtained by the accumulating in a register; and
generate the in-memory computation result by determining a sum of partial results stored in the register through the adder, or
wherein an intra-channel PE of the memory device is configured to generate a first sum result by determining a sum of embedding vectors of banks in the same rank among embedding vectors selected as the same segment in a tensor to be determined, and for the generating of the in-memory computation result, the channel-level PE is configured to:
obtain an intermediate result based on a sum of the first sum result and another first sum result in the same channel among the embedding vectors selected as the same segment;
generate a partial result by accumulating intermediate results obtained from respective channels, and store a generated partial result in a register; and
generate the in-memory computation result by determining a sum of partial results.

6. The memory device of one of claims 1 to 5, wherein, for the performing of the operation, the channel-level PE is configured to perform any one or any combination of any two or more operations among addition, subtraction, multiplication, division, multiply-accumulate, MAC, operation, and reduction operation on inter-channel data.

7. The memory device of one of claims 1 to 6, further comprising an intra-channel PE configured to generate a partial result by performing an operation on data of memory banks belonging to the same channel among the plurality of memory banks,
wherein, for the performing of operation on data of the memory banks, the intra-channel PE is configured to perform any one or any combination of any two or more operations among addition, subtraction, multiplication, division, MAC operation, and reduction operation on intra-channel data.

8. The memory device of one of claims 1 to 7, further comprising one or more of:
a bank-level PE configured to perform an operation on data of memory banks belonging to the same rank among the plurality of memory banks;
a rank-level PE configured to perform an operation between different memory ranks belonging to the same channel among a plurality of memory ranks;
a first bank-level PE configured to generate a first bank-level result through an operation on data stored in different banks in the first channel, and a first rank-level PE configured to generate the first partial result based on the first bank-level result generated by the first bank-level PE; and
a second bank-level PE configured to generate a second bank-level result through an operation on data stored in different banks in the second channel, and a second rank-level PE configured to generate the second partial result based on the second bank-level result generated by the second bank-level PE.

9. The memory device of one of claims 1 to 8, wherein the plurality of memory banks forms a tree structure.

10. The memory device of one of claims 1 to 9, wherein
the channel-level PE is in a logic die of the memory device, and
the plurality of memory banks is in a core die of the memory device.

11. The memory device of claim 10, wherein
the logic die and a plurality of memory core dies are stacked, and
partial results of memory channels in the plurality of memory core dies are collectively processed in the channel-level PE in the logic die, or
wherein a computation result obtained by the channel-level PE in the logic die is transmitted to a host processor of a processor die through an interposer.

12. The memory device of one of claims 1 to 11, wherein
the channel-level PE comprises a plurality of operators each corresponding to a respective one of the channels and configured to perform an operation between a partial result corresponding to the channel and a previously generated partial result stored in a register corresponding to the operator, and
an adder configured to, for the generating of the in-memory computation result, determine a sum of outputs of the plurality of operators.

13. An electronic device comprising:
the memory device of claim 2; and
the host processor.

14. A computer-readable storage medium storing instructions that, when executed by one or more processors, configure the one or more processors to perform the steps of:
generating a first partial result based on data stored in a memory bank of a first channel among a plurality of memory banks and generating a second partial result based on data stored in a memory bank of a second channel among the plurality of memory banks; and
generating an in-memory computation result by performing an operation using the first partial result and the second partial result by a channel-level processing element, PE.

15. A processor-implemented method of operating a memory device comprising the steps of:
generating, by a first memory rank comprising a bank-level processing element, PE, a bank-level result through an operation on data stored in banks of the first memory rank;
generating, by a first memory channel comprising the first memory rank, a second memory rank, and an intra-channel PE, a partial result by performing an operation on the bank-level result of the first memory rank and a bank-level result of the second memory rank; and
generating, by a channel-level PE, an in-memory computation result by performing an operation using the partial result of the first memory channel and a partial result of a second memory channel, and transmitting, by the channel-level PE, the in-memory computation result to a host processor.
